# EUROPEAN PATENT APPLICATION

(11) **EP 2 381 748 A1**
(43) Date of publication of application: **26.10.2011**
(21) Application number: 09836213.0
(22) Date of filing: 24.12.2009
(51) Int. Cl.: H05K 1/11, H05K 3/40, H05K 3/46

(54) **PRINTED WIRING BOARD AND METHOD FOR MANUFACTURING SAME**

(30) Priority: 29.12.2008 US 141147 P; 23.12.2009 US 645791
(71) Applicant: Ibiden Co., Ltd., Ogaki-shi, Gifu 503-8604 (JP)
(72) Inventor: KAJIHARA Kazuki, Ogaki-shi Gifu 503-0027 (JP)
(74) Representative: HOFFMANN EITLE
(86) International application number: PCT/JP2009/071498
(87) International publication number: WO 2010/076875

(57) **Abstract**

Disclosed is a printed wiring board (1) comprising: a substrate (10) which is composed of a sheet-like reinforcing material (14) and a resin (15); a first conductor circuit (11) and a second conductor circuit (12), which are respectively formed on the major surfaces of the substrate (10); a through hole which is configured of a first opening that is tapered from a first surface toward a second surface of the substrate (10) and a second opening that is tapered from the second surface toward the first surface; and a through hole conductor (13) which is obtained by filling the through hole with a metal. The first conductor circuit (11) and the second conductor circuit (12) are electrically connected with each other by the through hole conductor (13). A part of the reinforcing material (14) protrudes into the through hole at the area where the first opening and the second opening intersect, so that the part of the reinforcing material (14) encroaches into the through hole conductor (13). Consequently, occurrence of voids within the through hole conductor (13) is suppressed as much as possible, and the mechanical bonding strength of the through hole conductor (13) is increased.

## Description

### Technical Field

The present invention relates to a printed wiring board provided with a through hole passing through an insulating substrate, and a method for manufacturing such, and in particular, to a printed wiring board in which the through hole is filled with metal, and a method for manufacturing such.

### Background Art

A method for filling the inside of a through hole with metal through plating from the perspective of improving electrical properties has been known from before.

For example, Patent Literature 1 discloses technology (a through hole fill method) for preventing the occurrence of voids or the like by making the shape of the through hole a drum shape. The drum-shaped through hole is a through hole made up of a first opening that is tapered from a first surface of the substrate toward a second surface of the substrate, and a second opening that is tapered from the second surface of the substrate toward the first surface of the substrate. The first opening and the second opening join inside the substrate.

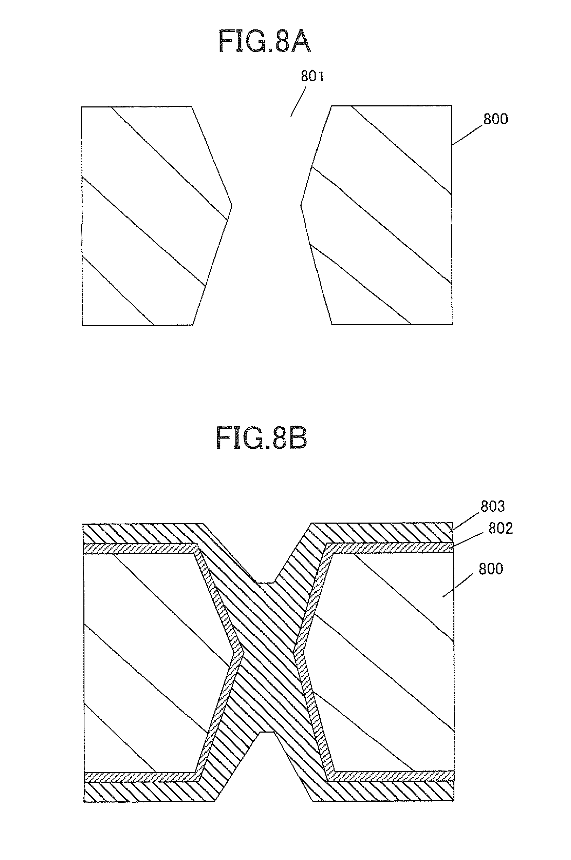

With this through hole fill method, a through hole 801 with a drum-shaped longitudinal cross-section is first formed in an insulating substrate 800, as shown in FIG. 8A. Next, seed layer 802 made of metal is formed on the inner wall surface of this through hole 801, as shown in FIG. 8B. From there, plated metal layer 803 is formed by filling the through hole with metal from the narrowest part (the part where the cross-sectional area is smallest) through electroplating.

### Prior Art Literature

### Patent Literature

Patent Literature 1: Unexamined Japanese Patent Application KOKAI Publication No. 2004-311919

### Disclosure of Invention

### Problem to be Solved by the Invention

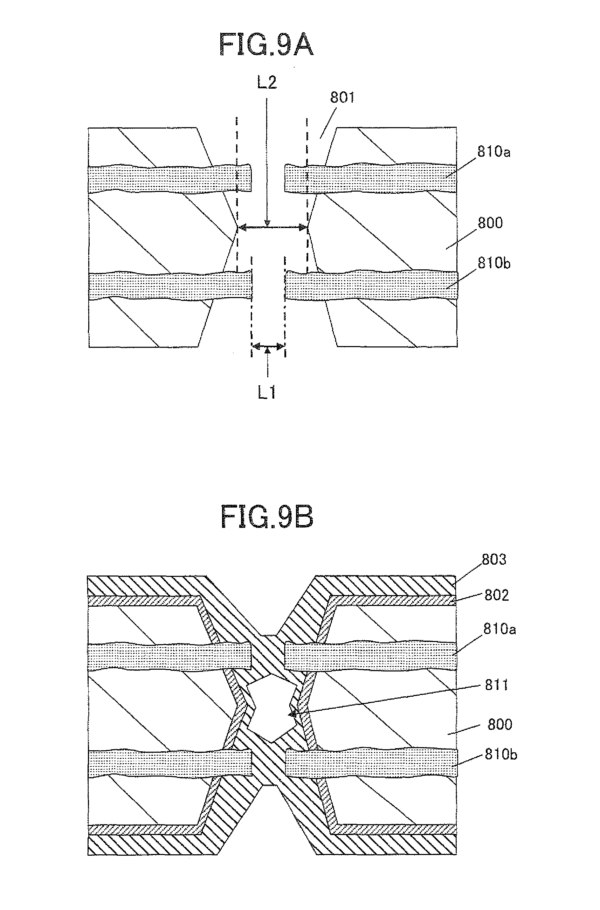

However, thermosetting substrates in which resin (such as epoxy resin or the like) is impregnated with a reinforcing material such as glass cloth or the like in order to give mechanical strength are widely used as insulating substrates used in printed wiring boards. When a through hole is formed in a substrate including this manner of reinforcing material on the basis of the technology disclosed in Patent Literature 1, there is a possibility that the reinforcing material could protrude from a wall surface of the resin. In such instances, a case could conceivably occur in which the hole diameter (L1) of the opening passing through the reinforcing material 810a and 810b is smaller than the diameter (L2) of the narrowest part of the through hole 801 passing through the resin, as shown in FIG. 9A.

In general, in a substrate composed of resin and two pieces of reinforcing material, it is conceivable that one reinforcing material 810a could be positioned not at the center of the substrate in the cross-sectional direction but between the center of the substrate and a first surface of the substrate, and the other reinforcing material 810b could be positioned between the center of the substrate and a second surface (the surface on the opposite side from the first surface) of the substrate, as shown in FIG. 9A. When the through hole of such a substrate is filled by plating (electroplating), it is conceivable that the part passing through the reinforcing materials 810a and 810b could be readily closed by plating (electroplated film) before the narrowest part of the through hole 801 passing through the substrate. In such a case, there are concerns that a void 811 could occur in the narrowest part of the through hole 801 passing through the resin, as shown in FIG. 9B.

It is an object of the present invention to provide a printed wiring board that suppresses as much as possible occurrence of voids inside the through hole conductor and also increases bonding strength between the through hole conductor and the insulating substrate, and a method for manufacturing such.

### Means for Solving the Problem

The printed wiring board according to the present invention is a printed wiring board comprising a substrate having a first surface and a second surface on the side opposite the first surface, and having a through hole comprising a first opening that is tapered from the first surface toward the second surface and a second opening that is tapered from the second surface toward the first surface; a first conductor circuit formed on the first surface of the substrate; a second conductor circuit formed on the second surface of the substrate; and a through hole conductor that fills the through hole and connects the first conductor circuit and the second conductor circuit; wherein the substrate is composed of a reinforcing material and a resin, and a portion of the reinforcing material protrudes into the through hole from the wall surface of the resin at the area where the first opening and the second opening intersect, and this protrusion of the reinforcing material encroaches into the through hole conductor.

In addition, the method for manufacturing a printed wiring board according to the present invention is a method for manufacturing a printed wiring board including a procedure for preparing a substrate composed of a resin and a reinforcing material and having a first surface and a second surface on the side opposite the first surface; a procedure for forming a first opening that tapers from the first surface of the substrate toward the second surface; a procedure for forming a second opening that tapers from the second surface of the substrate toward the first surface, so that a through hole is formed comprising the first opening and the second opening; a procedure for forming a through hole conductor by filling the through hole with plating; and a procedure for forming a conductor circuit that connects the first surface and the second surface of the substrate by the through hole conductor; wherein in the procedure for forming the through hole, the through hole is formed such that the reinforcing material protrudes from the wall surface of the resin into the through hole at the intersection area where the first opening and the second opening intersect; and in the procedure for forming the through hole conductor, the through hole is filled with plating from the intersection area toward the first surface and the second surface of the substrate.

### Effect of the Invention

With the present invention, it is possible to suppress as much as possible occurrence of voids inside the through hole conductor in a printed wiring board and in addition to increase the bonding strength between the through hole conductor and the insulating substrate.

### Brief Description of Drawings

FIG. 1A is a cross-section of a copper clad laminate used in Embodiment 1 of the present invention.
FIG. 1B is a cross-section showing the state when an alignment mark is formed in the substrate of FIG. 1A.
FIG. 1C is a cross-section showing the state when a first opening is formed in a first surface of the substrate of FIG. 1B.
FIG. 1D is a cross-section showing the state when a second opening is formed in a second surface of the substrate of FIG. 1C.
FIG. 1E is a cross-section showing the state after non-electroplating has been conducted on the substrate of FIG. 1D.
FIG. 1F is a cross-section showing the state after electroplating has been conducted on the substrate of FIG. 1E.
FIG. 1G is a cross-section showing the state with plating filling the part where a protrusion exists, when electroplating.
FIG. 1H is a cross-section showing the state when etching resists are formed on the substrate of FIG. 1F.
FIG. 1I is a cross-section showing the state after etching has been conducted on the substrate of FIG. 1H.
FIG. 2 is a cross-section showing of a printed wiring board according to Embodiment 1 of the present invention.
FIG. 3 is a cross-section of a build-up multi-layer printed wiring board using the printed wiring board of FIG. 2.
FIG. 4 is a cross-section of a printed wiring board according to Embodiment 2 of the present invention.
FIG. 5A is a cross-section of a copper clad laminate used in Embodiment 2 of the present invention.
FIG. 5B is a cross-section showing the state after through holes have been formed in the substrate of FIG. 5A.
FIG. 5C is a cross-section showing the state after non-electroplating has been conducted on the substrate of FIG. 5B.
FIG. 5D is a cross-section showing the state after electroplating has been conducted on the substrate of FIG. 5C.
FIG. 5E is a cross-section showing the state when an etching resists are formed on the substrate of FIG. 5D.
FIG. 5F is a cross-section showing the state after etching has been conducted on the substrate of FIG. 5E.
FIG. 6 is a cross-section of a build-up multi-layer printed wiring board using the printed wiring board of FIG. 4.
FIG. 7A is a cross-section showing the state of an essential part (pattern 1) after a non-electroplated film has been formed in another embodiment.
FIG. 7B is a cross-section showing the state of an essential part (pattern 2) after a non-electroplated film has been formed in another embodiment.
FIG. 7C is a cross-section showing the state of an essential part (pattern 3) after a non-electroplated film has been formed in another embodiment.
FIG. 7D is a cross-section showing the state of an essential part (pattern 4) after a non-electroplated film has been formed in another embodiment.
FIG. 8A is a cross-section showing a drum-shaped through hole in an example of prior art technology.
FIG. 8B is a cross-section showing the state when the through hole of FIG. 8A is filled with metal.
FIG. 9A is a cross-section showing the state after the through hole has been formed, and is a drawing used to explain one conceivable problem the prior art technology possesses.
FIG. 9B is a cross-section showing the state when the through hole of FIG. 9A is filled with metal.

### Mode for Carrying Out the Invention

The printed wiring board and method for manufacturing same according to the preferred embodiments of the present invention are described below with reference to the drawings.

### (Embodiment 1)

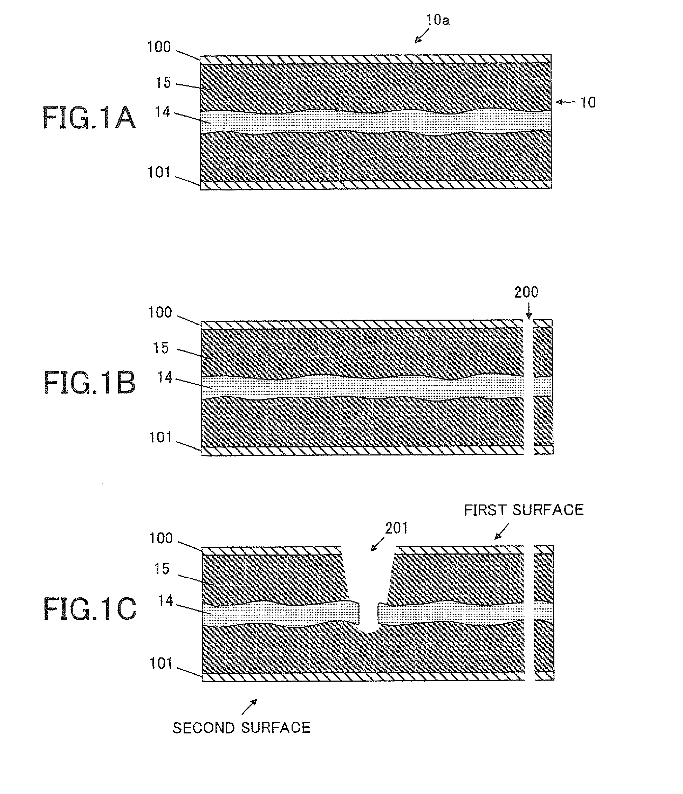

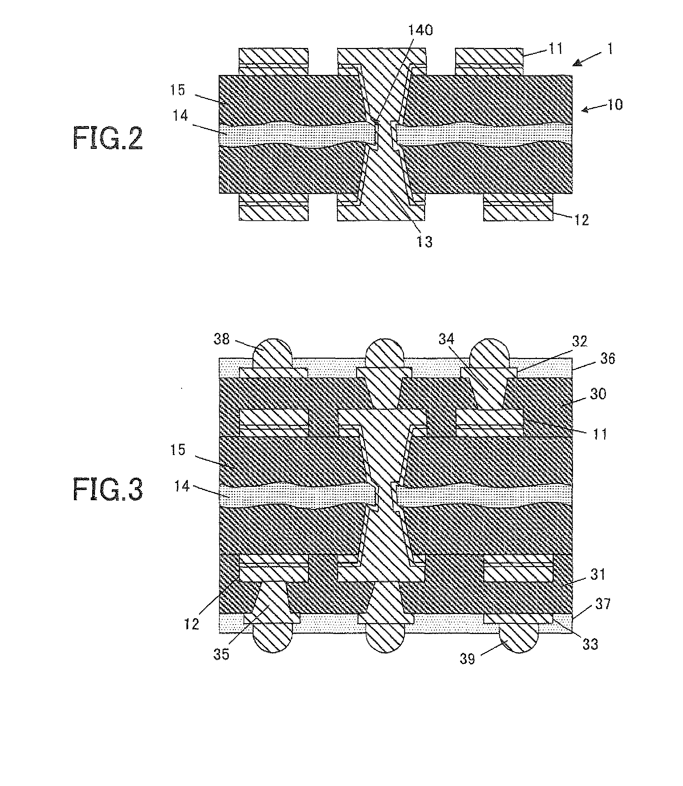

A method for manufacturing a printed wiring board 1 (see FIG. 2) according to Embodiment 1 is described with reference to FIGS. 1A to 1I.

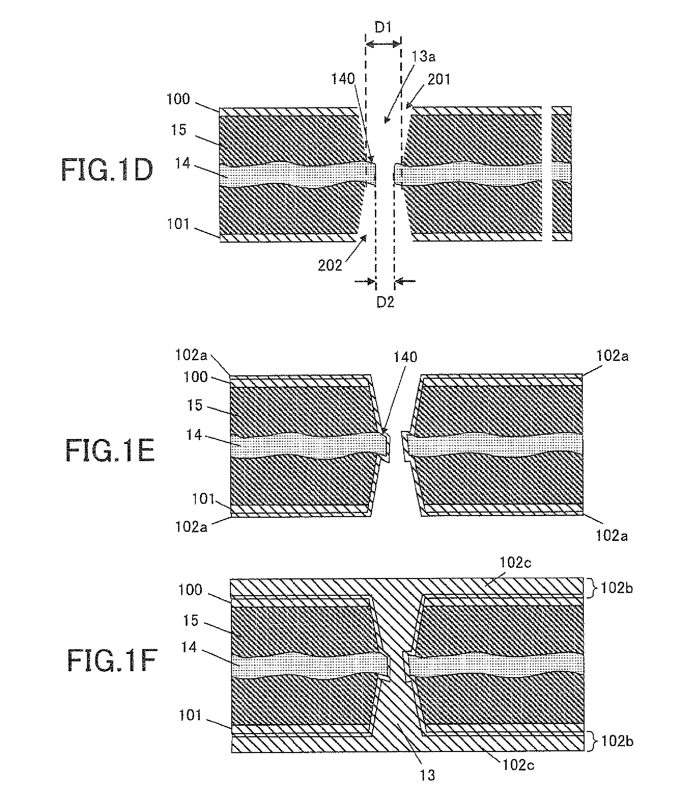

First, as shown in FIG. 1A, a copper clad laminate in which copper foils 100 and 101 roughly 12 µm thick are laminated is prepared on both major surfaces of an insulating substrate 10 that is 0.1 mm to 0.6 mm thick. The thickness of the insulating substrate 10 is preferably 0.3 mm to 0.4 mm. When in this range, it is possible to secure strength in the substrate and it is easy to form a through hole shown in FIG. 1D using a laser. The insulating substrate 10 is composed of one piece of reinforcing material 14 and hardened resin 15. In this embodiment, the reinforcing material 14 is positioned substantially in the center of the insulating substrate 10 in the direction of thickness substantially parallel to both major surfaces of the insulating substrate 10.

As a reinforcing material, it is possible to utilize glass cloth, glass nonwoven cloth or aramid nonwoven cloth. Of these, from the perspective of strength it is preferable to use a sheet-like reinforcing material composed of glass cloth, and the thickness of the reinforcing material 14 is preferably 0.09 mm to 0.15 mm.

A method for manufacturing a substrate in which the thickness of the insulating substrate is large with respect to the thickness of the reinforcing material will be simply explained. First, resin is impregnated with the reinforcing material and caused to dry. Next, resin is coated on both surfaces of the dried substrate. Following this, an insulating substrate with large thickness is obtained by the resin curing.

Next, an alignment mark 200 is formed passing through the copper clad laminate 10a (see FIG. 1B). The alignment mark 200 can be formed by drill or laser. The alignment mark 200 is preferably a substantially straight through hole. Next, the copper foil 100 and 101 of this copper clad laminate 10a is oxidized by a black oxide treatment.

Next, a laser is beamed at a prescribed spot on one of the major surfaces (a first surface) of the copper clad laminate 10a to form a first opening 201 (see FIG. 1C). As the laser, a carbon dioxide gas (CO₂) laser, Nd-YAG laser or excimer laser or the like can be used. The first opening 201 tapers from the first surface of the copper clad laminate 10a toward a second surface (a surface on the side opposite the first surface). Tapering from the first surface toward the second surface includes gradually narrowing from the first surface toward the second surface. The first opening 201 is formed with the alignment mark 200 as a reference.

Following this, a laser is beamed on a prescribed spot on the second surface of the copper clad laminate 10a to form a second opening 202 (see FIG. 1D). The second opening 202 tapers from the second surface of the copper clad laminate 10a toward the first surface. The second opening 202 is also formed with the alignment mark 200 as a reference. Tapering from the second surface toward the first surface includes gradually narrowing from the second surface toward the first surface.

The first opening 201 and the second opening 202 are formed with the same alignment mark 200 as a reference, so positioning with good accuracy is possible. Through this, the first opening 201 and the second opening 202 join at an area that is neither the first surface nor the second surface of the copper clad laminate 10a (inside the copper clad laminate 10a). As a result, a through hole (penetrating hole) 13a composed of the first opening 201 and the second opening 202 is formed, as shown in FIG. 1D.

As described above, the copper clad laminate 10a has a reinforcing material 14. Normally, when comparing resin and reinforcing materials, resin is more readily processed than reinforcing materials. Consequently, the diameter of the opening of the through hole readily becomes smallest at the position where the reinforcing material exists. In addition, in the present embodiment, the reinforcing material 14 is positioned substantially in the center of the copper clad laminate 10a, so it is easy for the opening diameter of the through hole 13a to become smallest at substantially the center of the copper clad laminate 10a.

As a result, the diameter of the through hole 13a of this embodiment becomes smaller from the first surface of the copper clad laminate 10a toward the reinforcing material 14 positioned at substantially the center of the inside, and the opening diameter becomes larger from the position where it is smallest toward the second surface, as shown in FIG. 1D. In addition, the opening diameter of the through hole 13a does not change gradually but preferably changes significantly at the area where the reinforcing material 14 is positioned. In addition, at the position where the opening diameter of the through hole 13a is the smallest, portion (protrusion 140) of the reinforcing material 14 protrudes from the resin 15.

As noted above, in this embodiment, there is protrusion 140 of reinforcing material 14 protruding in the through hole 13a at substantially the center of the copper clad laminate 10a. Consequently, the through hole 13a of this embodiment readily forms a shape having a difference in levels at substantially the center (the position where the reinforcing material 14 exists) of the copper clad laminate 10a (see FIG. 1D).

As shown in FIG. 1D, the minimum diameter of the through hole 13a (the opening diameter D2 formed by the reinforcing material 14) and the opening diameter D1 formed by the resin 15 at that position are preferably related such that D2/D1 = 1/4 to 9/10. When D2/D1 is in this range, it is easy to fill the inside of the through hole 13a by plating.

The length of protrusion 140 can be changed by adjusting the laser irradiation energy, the density thereof, the number of laser irradiations or the like, for example.

Next, a treatment (desmear treatment) for removing smears and the like remaining on the inner surface of the through hole 13a is accomplished. The besmear treatment is accomplished using the permanganate method. Specifically, first a conditioning (resin swelling) treatment is conducted on the copper clad laminate 10a of FIG. 1D. Following this the laminate is immersed for 5 to 30 minutes in a desmear treatment liquid of 40 to 80 g/l of permanganate at a temperature of 50 to 80° C. After this, the laminate is rinsed in water, immersed in a neutralizing solution, then rinsed in water and dried. As a result, smears are removed from the inner surface of the through hole 13a and a clean surface is exposed.

Following the desmear treatment, a conditioning treatment and a soft-etching (also called micro-etching) treatment are conducted on the copper clad laminate 10a. After this, the laminate is immersed in a catalyzing liquid containing alkaline Pd complex ions, and a catalyst for starting non-electroplating (such as non-electroplated copper and non-electroplated nickel) are adsorbed to both major surfaces of the copper clad laminate 10a and the inner surface of the through hole 13a.

Furthermore, when the copper clad laminate 10a with this catalyst adsorbed is immersed in a non-electroplating liquid, a substrate is obtained in which non-electroplated film (for example, non-electroplated copper film or non-electroplated nickel film) 102a is formed on both major surfaces and the inner surface of the through hole 13a, as shown in FIG. 1E. In addition, at this time non-electroplated film 102a is also deposited on protrusion 140 protruding to the inside of the through hole 13a from the wall surface of the resin 15 in the center of the through hole 13a.

Next, an electroplating treatment (for example, an electrolytic copper plating treatment or an electrolytic nickel treatment) is accomplished with non-electroplated film 102 as a seed layer, the through hole 13a is filled with plating (for example, electroplating such as electrolytic copper plating or electrolytic nickel or the like) and a through hole conductor (composed of non-electroplated film and electroplated film on non-electroplated film) 13 is formed (see FIG. 1F). In addition, at this time electroplated film 102c is formed on non-electroplated film 102a on both major surfaces of the substrate, and for example plated film 102b composed of non-electroplated film 102a and electroplated film 102c is formed.

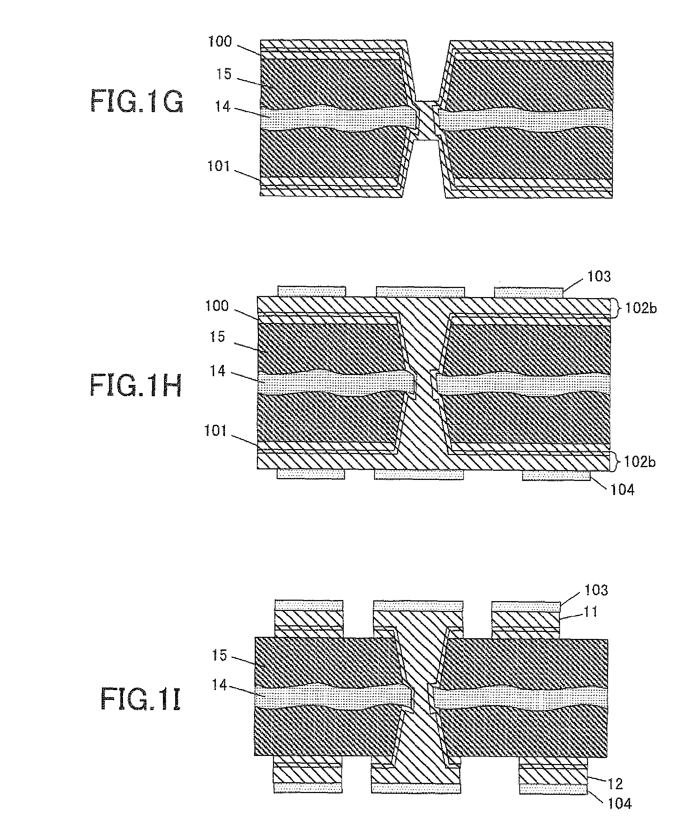

In this embodiment, there is protrusion 140 that protrudes to the inside of the through hole 13a from the resin 15, as shown in FIG. 1D. Accordingly, at the area where protrusion 140 is formed, the opening diameter of the through hole 13a readily becomes a minimum. In addition, as shown in FIG. 1E, non-electroplated film 102a is formed on the surface (that is to say, the inner wall of the through hole 13a) of protrusion 140 and the resin 15 exposed by the through hole 13a. When filling the through hole 13a with electroplating, this non-electroplated film 102a functions as a seed layer. In this embodiment, during electroplating the plating readily fills the space formed by the inner walls of protrusion 140 first (see FIG. 1G). After this, the through hole 13a is filled with plating from the area where protrusion 140 exists toward the first surface and the second surface of the substrate.

As described above, because of the existence of protrusion 140 protruding from the inner walls of the through hole 13a, the through hole 13a is filled with plating from the narrowest area (the area where protrusion 140 exists). In addition, with this embodiment, a copper clad laminate 10a containing a single sheet of reinforcing material 14 is used, so protrusion 140 protruding from the inner walls of the through hole 13a is concentrated in one area (the center of the substrate). Accordingly, it is difficult for multiple areas in the through hole 13a to be simultaneously closed up with plating. In addition, because the volume of the space formed by the inner walls of protrusion 140 is small, it is difficult for voids to occur at the area having the smallest opening diameter (the space formed by the inner walls of protrusion 140). Consequently, it is easy for the through hole 13a to be filled with plating from the center of the substrate toward the first surface and the second surface of the substrate.

In the case of this embodiment, the reinforcing material 14 is positioned substantially in the center of the substrate and protrusion 140 is also positioned substantially in the center of the substrate. Consequently, filling with plating progresses substantially simultaneously from the center of the substrate toward the first surface and the second surface. As a result, it is easy for the thickness of plating film 102b formed on the first surface and the second surface of the substrate to become thin. Through this, processing with subsequent processes such as etching becomes easier, making it easy to make conductor circuits finer.

Next, etching resists 103 and 104 for protecting conductive patterns that are to remain are formed on the surfaces of plating film (for example, copper plating film) 102b, as shown in FIG. 1H.

Furthermore, plating film 102b exposed from the etching resists 103 and 104 and copper foils 100 and 101 are etched to form conductor circuits 11 and 12 (see FIG. 1I). After etching, etching resists 103 and 104 are peeled off to obtain the printed wiring board 1 shown in FIG. 2.

The printed wiring board 1 of this embodiment manufactured as described above has the below-described excellent characteristics in addition to the above-described characteristic that the occurrence of voids inside the through hole conductor 13 is suppressed as much as possible.

The through hole conductor 13 is formed in a tapered shape toward the center of the printed wiring board 1, and consequently the mechanical bonding strength with the insulating substrate 10 is high.

Because protrusion 140 (part of the reinforcing material 14) protruding from the resin 15 encroaches into the center of the through hole conductor 13, it is possible to effectively ease the pulling stress in the vertical direction of the through hole conductor 13. Accordingly, the bonding strength between the insulating substrate 10 and the through hole conductor 13 is further increased.

This kind of printed wiring board 1 is used as the core substrate of a multi-layer printed wiring board. FIG. 3 shows one example of a build-up multi-layer printed wiring board using the printed wiring board 1 of FIG. 2 as the core substrate. The process for manufacturing this build-up multi-layer printed wiring board is briefly explained below.

First, interlayer resin insulating layers 30 and 31 are formed on the first surface and the second surface, respectively of the printed wiring board 1 of FIG. 2. Following this, openings reaching conductor circuits 11 and 12 formed on the printed wiring board 1 are formed in interlayer resin insulating layers 30 and 31. Next, conductor circuits 32 and 33 are formed on interlayer resin insulating layers 30 and 31, respectively. Here, via conductors 34 and 35 are formed simultaneously in the openings of interlayer resin insulating layers 30 and 31, respectively. Through this, conductor circuit 11 and conductor circuit 32 are electrically connected by via conductor 34, and conductor circuit 12 and conductor circuit 33 are electrically connected by via conductor 35.

Next, a liquid or dry film photosensitive resist (solder resist) is coated or laminated on both major surfaces of the substrate. Thermosetting solder resist may also be used.

Furthermore, a mask film in which a prescribed pattern is formed is adhered to the surface of the photosensitive resist, this is exposed to ultraviolet rays and then developed by an alkaline solution. As a result, solder resist layers 36 and 37 having openings for exposing parts that are solder pads of conductor circuits 32 and 33 are formed.

The openings having solder resist layers 36 and 37 may be openings exposing part of the top surfaces of via conductors 34 and 35. In addition, these may also be openings exposing the entire top surfaces of via conductors 34 and 35 and parts of conductor circuits 32 and 33 directly connected to the conductors 34 and 35.

Next, solder paste is imprinted on the solder pads and solder bumps 38 and 39 are formed by accomplishing reflow. The build-up multi-layer printed wiring board of FIG. 3 formed in this manner is electrically connected to a daughter board or the like or to electronic components such as an IC chip or the like via solder bumps 38 and 39.

In this embodiment, the copper clad laminate 10a used has a single sheet of reinforcing material 14, and this reinforcing material 14 is positioned substantially in the center of the insulating substrate 10. In addition, in the center region of the through hole conductor 13, protrusion 140 of the reinforcing material 14 protruding from the inner wall, encroaches into the through hole conductor 13.

However, the positioning condition of the reinforcing material 14 and the shape of the through hole conductor 13 and so forth are not limited. All that is necessary is for protrusion 140 of the reinforcing material 14 to exist at the intersection of the first opening 201 and the second opening 202. By having the reinforcing material 14 exist at the intersection of the first opening 201 and the second opening 202, it is possible to make the diameter of the opening of the intersection the minimum diameter of the through hole 13a. In addition, the location where the opening diameter is smallest readily becomes a single location in the cross-sectional direction of the through hole 13a.

### (Embodiment 2)

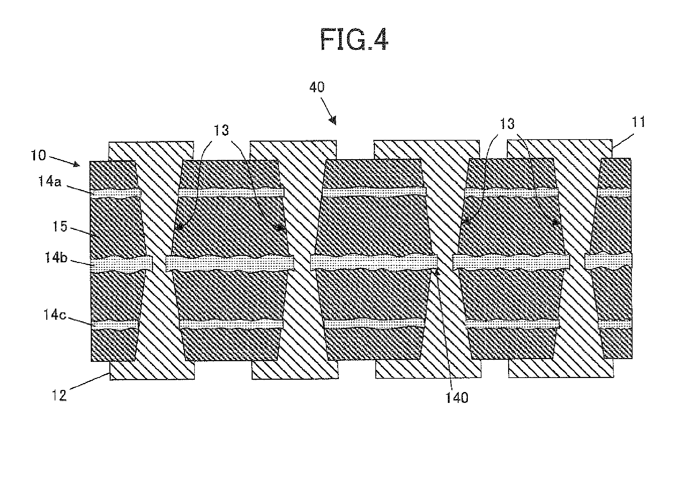

FIG. 4 is a cross-sectional view of a printed wiring board 40 according to Embodiment 2. In this printed wiring board 40, the insulating substrate 10 is composed of three sheets of reinforcing material 14a, 14b and 14c and a hardened resin 15. The reinforcing material 14b is positioned substantially at the center of the insulating substrate 10. The reinforcing material 14a is positioned between the center and a first surface of the insulating substrate 10. The reinforcing material 14c is positioned between the center and a second surface of the insulating substrate 10. In addition, portion of the reinforcing material 14b (protrusion 140) encroaches into each through hole conductor 13.

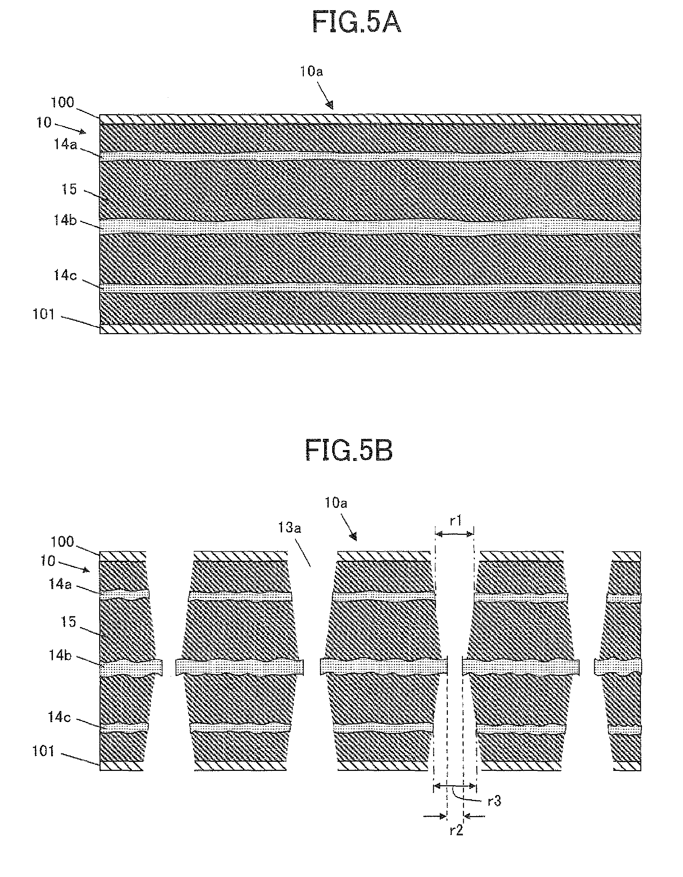

The method for manufacturing this printed wiring board 40 is described below with reference to FIGS. 5A to 5F. First, as shown in FIG. 5A, a copper clad laminate 10a is prepared on which copper foils 100 and 101 having a thickness of 12 µm are laminated on both major surfaces of the insulating substrate 10 having a thickness of approximately 0.4 mm. In this embodiment, the insulating substrate 10 is a substrate in which three sheets of reinforcing materials 14a to 14c are immersed in resin and the resin is hardened. These three sheets of reinforcing material 14a to 14c are each positioned substantially parallel to both major surfaces of the copper clad laminate 10a.

Next, an alignment mark (unrepresented) passing through the copper clad laminate 10a is formed. Furthermore, copper foils 100 and 101 of this copper clad laminate 10a are oxidized by a black oxide treatment. Next, through holes 13a composed of a first opening and a second opening are formed at prescribed locations in the copper clad laminate 10a (see FIG. 5B). The first opening tapers from the first surface of the copper clad laminate 10a toward the second surface. The second opening tapers from the second surface of the copper clad laminate 10a toward the first surface. The method for forming through holes 13a is the same as that of Embodiment 1.

With this embodiment, the reinforcing material 14b exists at the intersection of the first and second openings. In other words, portion (protrusion) of the reinforcing material 14b exists at the intersection of the first and second openings. In addition, the opening diameter of the through hole 13a is smallest at the intersection of the first and second openings. The reinforcing materials 14a and 14c may also have protrusions protruding into the through hole 13a from the resin 5. However, the opening diameter (r1) of the opening formed in the reinforcing material 14a is larger than the opening diameter (r2) of the opening formed in the reinforcing material 14b. In addition, the opening diameter (r3) of the opening formed in the reinforcing material 14c is also larger than r2.

As a method for forming through holes satisfying r1 > r2 and r3 > r2, for example, a method for forming the first and second openings through laser light with higher energy density in the center than at the perimeter can be cited. In addition, by changing the thicknesses of reinforcing materials, it is possible to form through holes satisfying r1 > r2 and r3 > r2. Specifically, the thickness of the reinforcing material 14b may be thicker than the thicknesses of the reinforcing materials 14a and 14c positioned above and below such. In this embodiment, the thickness of the reinforcing material 14b is thicker than the thickness of the reinforcing materials 14a and 14c (that is to say, the thickness of the reinforcing materials 14a and 14c is thinner than the thickness of the reinforcing material 14b). In this case, the thickness of the reinforcing material 14b is preferably 0.12 to 0.15 mm, and the thickness of the reinforcing materials 14a to 14c is preferably 0.09 to 0.12 mm. In addition, the difference in thicknesses between the reinforcing material 14b and the reinforcing materials 14a and 14c is preferably on the order of 0.015 to 0.05 mm.

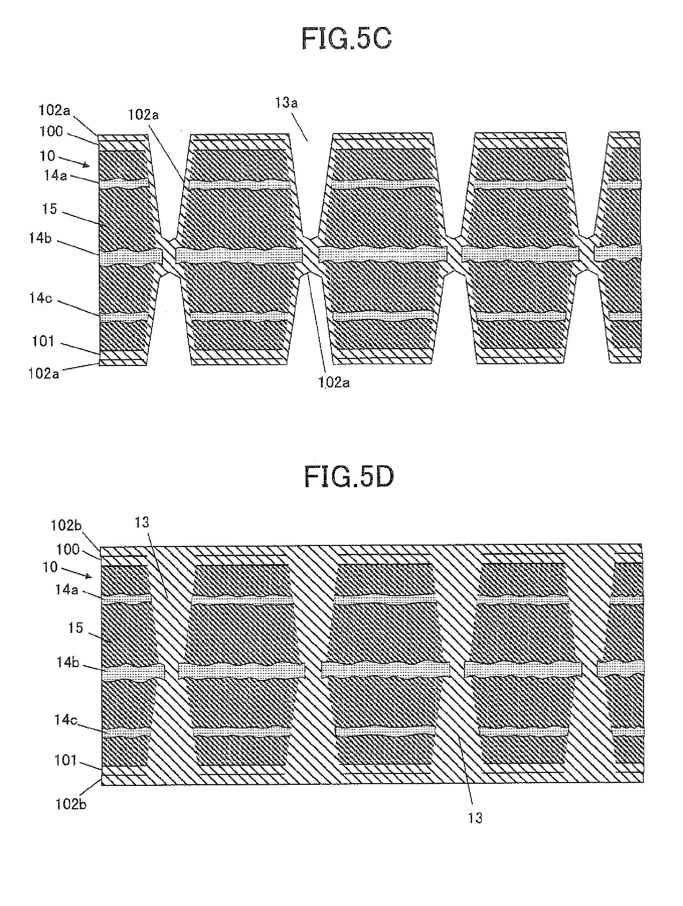

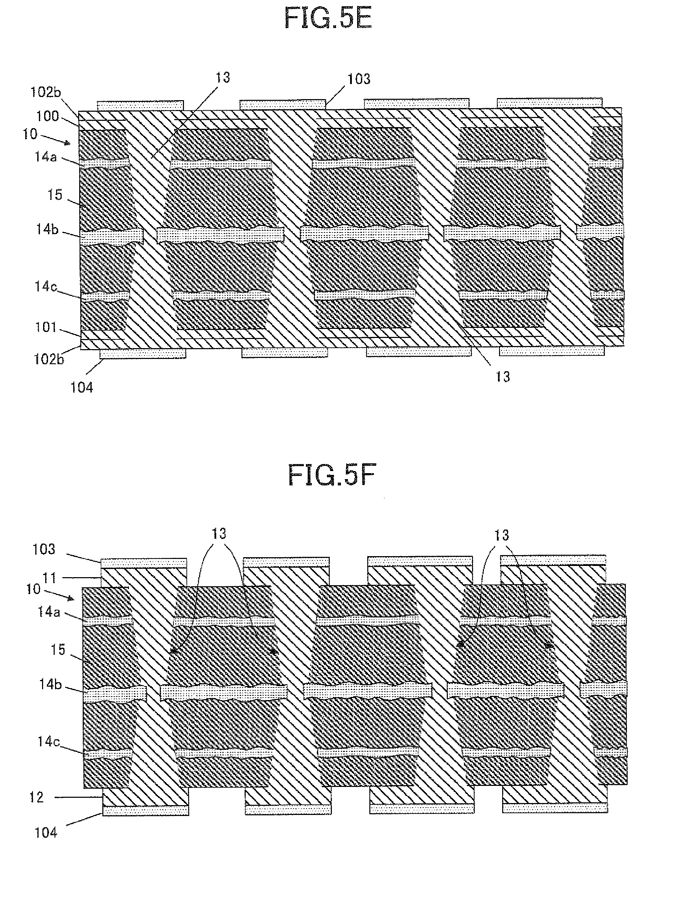

After formation of through holes 13a, non-electroplated film 102a is formed on both major surfaces of the copper clad laminate 10a and inner walls of through holes 13a (see FIG. 5C). Through this, the spaces formed by the inner walls of the reinforcing material 14b are filled by non-electroplated film 102a. After formation of non-electroplated film 102a, an electroplating treatment is accomplished to form plating film 102b and through hole conductors 13 (see FIG. 5D). After this, etching resists 103 and 104 for protecting conductor patterns that should remain are formed on the surface of plating film 102b, as shown in FIG. 5E.

Furthermore, plating film 102b and copper foils 100 and 101 exposed from etching resists 103 and 104 and are etched to form conductor circuits 11 and 12 (see FIG. 5F). After etching, by conducting a step to remove the etching resists, the printed wiring board 40 shown in FIG. 4 is obtained.

The printed wiring board 40 of this embodiment manufactured as described above has increased substrate strength because three sheets of reinforcing material 14a to 14c are used. In addition, because the number of reinforcing materials is an odd number similar to the printed wiring board 1 of Embodiment 1, it is easy to position the reinforcing material (14b) in the center of the insulating substrate 10. As a result, the diameter of the through hole 13a readily becomes smallest at the center of the insulating substrate 10. Furthermore, by positioning the reinforcing material 14b in the center of the insulating substrate 10. the balance is good in the direction of thickness of the printed wiring board 40, so curving of the substrate can be suppressed.

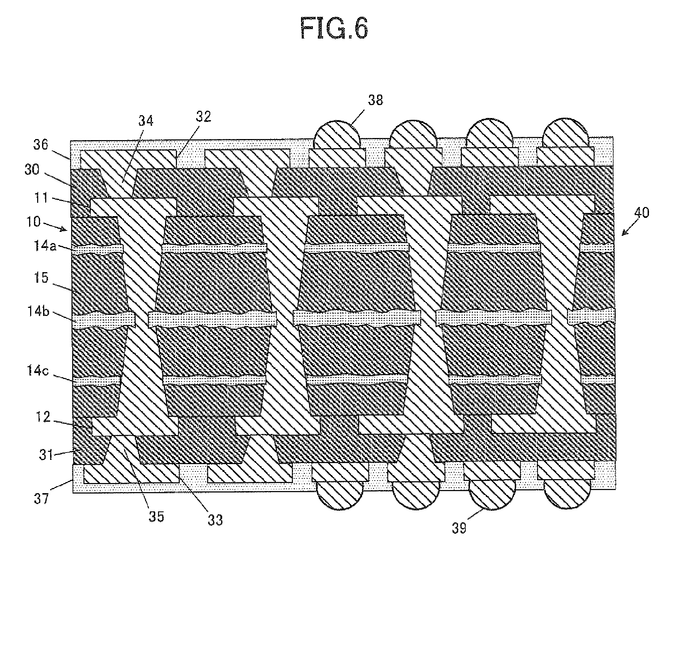

In addition, a multi-layer printed wiring board such as that shown in FIG. 6 can be obtained by forming build-up layers using the printed wiring board 40 as the core substrate. In FIG. 6, references numbers 30 and 31 indicate inter-layer resin insulating layers, reference numbers 32 and 33 indicate conductor circuits, reference numbers 34 and 35 indicate via conductors, reference numbers 36 and 37 indicate solder resist layers and reference numbers 38 and 39 indicate solder bumps.

The present invention is not limited by the above-described embodiments, for various alterations are possible without departing from the principles of the present invention

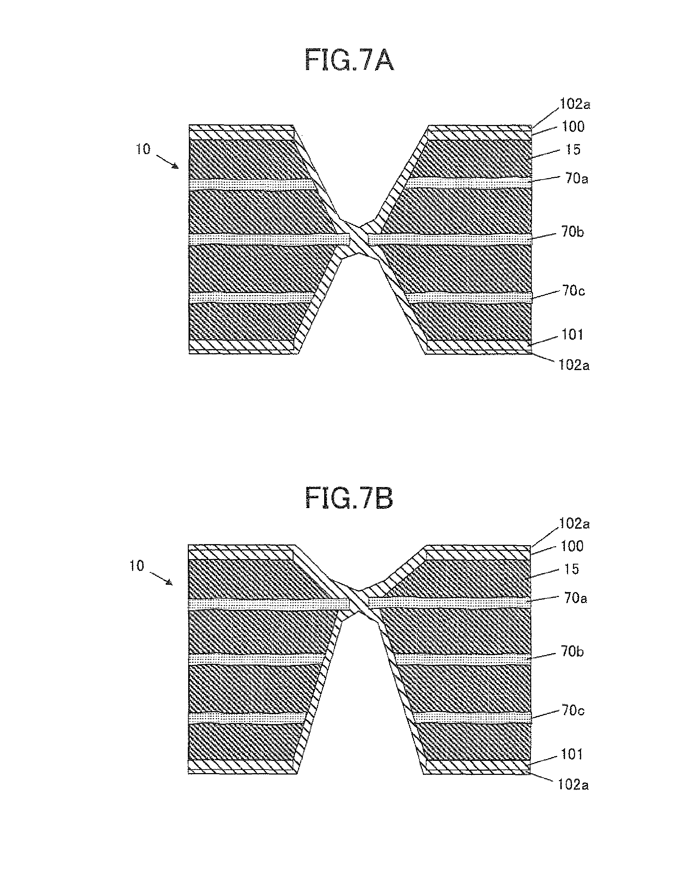

FIGS. 7A to 7D are summary cross-sections showing the state of essential parts after formation of non-electroplated films 102a in other embodiments. In FIGS. 7A and 7B, the insulating substrate 10 contains three sheets of reinforcing material 70a to 70c, and the thickness of each reinforcing material 70 is the same (for example, 100 µm).

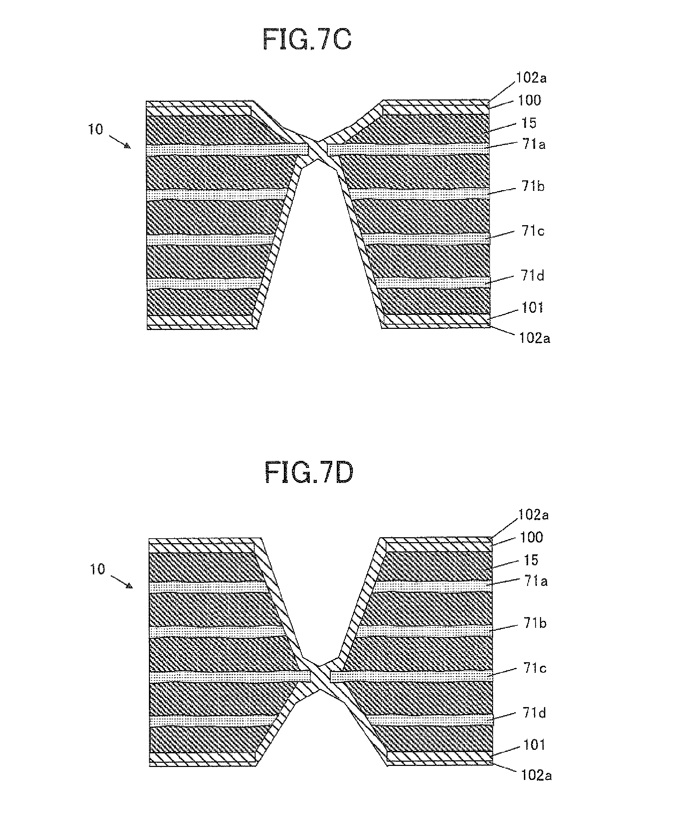

In FIGS. 7C and 7D, the insulating substrate 10 contains four (that is to say, an even number of) sheets of reinforcing material 71a to 71d, and the thickness of each reinforcing material 71 is the same (for example, 100 µm).

The smallest diameter of the through hole in FIGS. 7A to 7D is at the intersection of the first and second openings, and in this area, reinforcing material protrudes into the through hole. In FIGS. 7B, 7C and 7D, the area where the opening diameter of the through hole is smallest is not positioned at substantially the center of the substrate. In FIGS. 7B and 7C, the intersection is positioned between the center of the substrate and the first surface. In FIG. 7D, the intersection is positioned between the center of the substrate and the second surface.

In this manner, the printed wiring board having the intersection between the center of the substrate and the first surface or the second surface of the substrate can be used preferably as the core substrate in the build-up multilayer printed wiring board shown in FIG. 3 or FIG. 6. That is because the stress added to the curved portions of through hole conductors is reduced. Moreover, in this case it is preferable for the number of sheets of reinforcing material to be an even number.

### Industrial Applicability

The art of the present invention can be broadly applied to printed wiring boards in which through holes are filled with metal.

### Explanation of Reference Numerals

- 1: printed wiring board
- 10: insulating substrate
- 11,12: conductor circuit
- 13: through hole conductor
- 14: reinforcing material
- 15: resin
- 140: protrusion

## Claims

1. A printed wiring board, comprising:
a substrate having a first surface and a second surface on the side opposite the first surface, and having a through hole comprising a first opening that is tapered from the first surface toward the second surface and a second opening that is tapered from the second surface toward the first surface;
a first conductor circuit formed on the first surface of the substrate;
a second conductor circuit formed on the second surface of the substrate; and
a through hole conductor that fills the through hole and connects the first conductor circuit and the second conductor circuit;
wherein the substrate is composed of a reinforcing material and a resin, and a portion of the reinforcing material protrudes into the through hole from the wall surface of the resin at the area where the first opening and the second opening intersect, and this protrusion of the reinforcing material encroaches into the through hole conductor.

2. The printed wiring board according to Claim 1, wherein the area where the first opening and the second opening intersect is substantially at the center of the substrate in the direction of width.

3. The printed wiring board according to Claim 1, wherein the reinforcing material is selected from one or more out of glass cloth, glass nonwoven cloth or aramid nonwoven cloth.

4. The printed wiring board according to Claim 1, wherein the substrate is composed of the resin and an odd number of sheets of reinforcing materials, and one sheet out of the plurality of sheets of reinforcing materials is positioned substantially at the center of the substrate in the direction of thickness.

5. The printed wiring board according to Claim 1, wherein the through hole conductor is composed of copper plating.

6. A method for manufacturing a printed wiring board, including:
a procedure for preparing a substrate composed of a resin and a reinforcing material and having a first surface and a second surface on the side opposite the first surface;
a procedure for forming a first opening that tapers from the first surface of the substrate toward the second surface;
a procedure for forming a second opening that tapers from the second surface of the substrate toward the first surface, so that a through hole is formed comprising the first opening and the second opening;
a procedure for forming a through hole conductor by filling the through hole with plating; and
a procedure for forming a conductor circuit that connects the first surface and the second surface of the substrate by the through hole conductor;
wherein in the procedure for forming the through hole, the through hole is formed such that the reinforcing material protrudes from the wall surface of the resin into the through hole at the intersection area where the first opening and the second opening intersect; and
in the procedure for forming the through hole conductor, the through hole is filled with plating from the intersection area toward the first surface and the second surface of the substrate.

7. The method for manufacturing a printed wiring board according to Claim 6, wherein the reinforcing material is positioned substantially at the center of the substrate in the direction of thickness.

8. The method for manufacturing a printed wiring board according to Claim 6, wherein the reinforcing material is selected from one or more out of glass cloth, glass nonwoven cloth or aramid nonwoven cloth.

9. The method for manufacturing a printed wiring board according to Claim 6, wherein the substrate is composed of the resin and a plurality of sheets of reinforcing materials, and one sheet out of the plurality of sheets of reinforcing materials is positioned substantially at the center of the substrate in the direction of thickness.

10. The method for manufacturing a printed wiring board according to Claim 9, wherein the substrate is composed of the resin and an odd number of sheets of reinforcing materials.

11. The method for manufacturing a printed wiring board according to Claim 6, wherein the through hole conductor is composed of a non-electroplated film formed on a side wall of the through hole and an electroplated film on the non-electroplated film.

12. The method for manufacturing a printed wiring board according to Claim 11, wherein the non-electroplated film is a non-electroplated copper film, and the electroplated film is an electroplated copper film.

13. The method for manufacturing a printed wiring board according to Claim 6, wherein the first opening and the second opening are formed with a common alignment mark as reference.
